(19) Europäisches Patentamt / European Patent Office / Office européen des brevets

(11) **EP 4 027 517 A1**

(12) **EUROPEAN PATENT APPLICATION**
published in accordance with Art. 153(4) EPC

(43) Date of publication:
**13.07.2022 Bulletin 2022/28**

(51) International Patent Classification (IPC):
**H03H 3/02** (2006.01)      **H03H 9/02** (2006.01)
**H03H 9/17** (2006.01)      **H03H 9/54** (2006.01)

(21) Application number: **20859838.3**

(86) International application number:
**PCT/CN2020/086562**

(22) Date of filing: **24.04.2020**

(87) International publication number:
**WO 2021/042741 (11.03.2021 Gazette 2021/10)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **02.09.2019 CN 201910823229**

(71) Applicants:
• **Tianjin University**
  **Tianjin 300072 (CN)**

• **Rofs Microsystem (Tianjin) Co., Ltd**
  **Tianjin 300462 (CN)**

(72) Inventors:
• **YANG, Qingrui**
  **Tianjin 300072 (CN)**
• **PANG, Wei**
  **Tianjin 300072 (CN)**
• **ZHANG, Menglun**
  **Tianjin 300072 (CN)**

(74) Representative: **Meyer-Dulheuer MD Legal
Patentanwälte PartG mbB
Speicherstraße 59
60327 Frankfurt am Main (DE)**

(54) **BULK ACOUSTIC WAVE RESONATOR WITH PIEZOELECTRIC LAYER HAVING INSERT STRUCTURE, AND FILTER AND ELECTRONIC DEVICE**

(57) The present disclosure relates to a bulk acoustic wave resonator, including: a substrate; an acoustic mirror; a bottom electrode; a top electrode; a piezoelectric layer; the region where the acoustic mirror, bottom electrode, piezoelectric layer, and top electrode overlap in the direction of the thickness of the substrate is the effective region of the resonator; the piezoelectric layer is provided with a composite insertion structure arranged along the edge of the effective region; the composite insertion structure includes a first insertion layer and a second insertion layer; in the top-down view of the resonator at least a part of the first insertion layer overlaps the effective region, and in the top-down view of the resonator the first insertion layer and the second insertion layer at least partially overlap; the first insertion layer is a metal material and the second insertion layer is air or a dielectric material, or the first insertion layer is a dielectric material and the second insertion layer is air. The present disclosure also relates to a filter and an electronic device.

FIG. 2A

**Description**

**TECHNICAL FIELD**

Embodiments of the present disclosure relate to the field of semiconductors, and in particular, to a bulk acoustic wave resonator, a filter, and an electronic device having one of the bulk acoustic wave resonator and the filter.

**BACKGROUND**

A bulk acoustic wave filter has been widely used in the current wireless communication systems due to its low insertion loss, high square coefficient, high power capacity and the like, and becomes an important component for determining quality of radio frequency signals received by or transmitted from the communication systems. Performance of the bulk acoustic wave filter is determined by a bulk acoustic wave resonator of the bulk acoustic wave filter. For example, a resonant frequency of the bulk acoustic wave resonator determines an operation frequency of the filter, an effective electromechanical coupling coefficient of the bulk acoustic wave resonator determines a bandwidth of the filter, and a quality factor of the bulk acoustic wave resonator determines insertion loss of the filter. When the filter has a predetermined structure, a quality factor thereof, especially the quality factor (or a series-parallel impedance) at a series resonant frequency and a parallel resonant frequency, will significantly affect a passband insertion loss. Therefore, it is important to improve the quality factor of the resonator when configuring the filter with high-performance. A quality factor (Qs) or series impedance (Rs) at the series resonant frequency of the bulk acoustic wave resonator is usually determined by electrode loss and material loss, and a quality factor (Qp) or parallel impedance (Rp) at the parallel resonant frequency of the bulk acoustic wave resonator is usually affected by boundary acoustic wave leakage. Therefore, when a material and an overlapping structure of the resonator are predetermined, improvement of Qs (or Rs) is limited. However, the boundary acoustic wave leakage may be effectively improved by changing a boundary structure of the resonator, thereby significantly improving the Qp (or Rp) of the resonator.

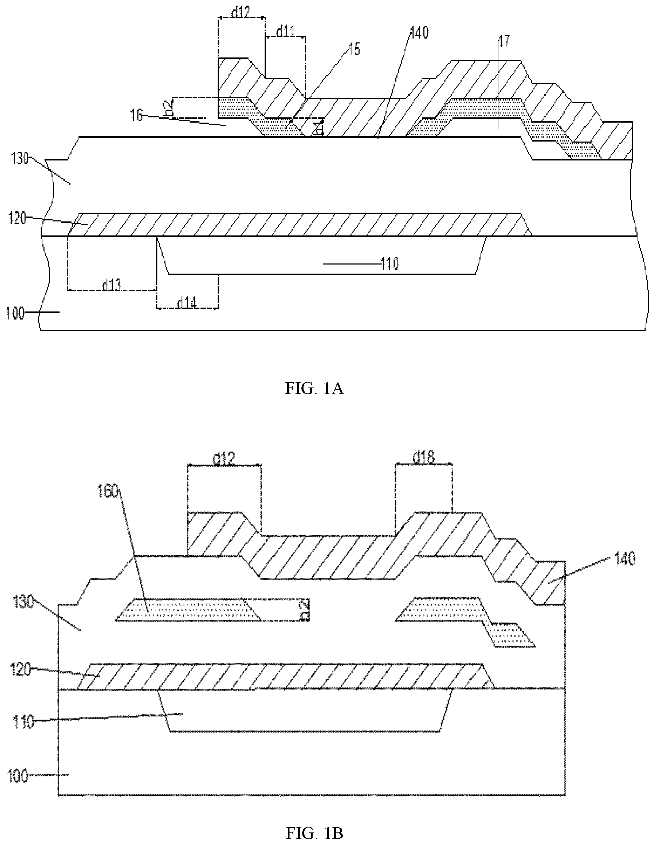

FIG. 1A is a schematic structural sectional view of a conventional film bulk acoustic wave resonator. As shown in FIG. 1, a reference sign 100 indicates a substrate, a reference sign 110 indicates an acoustic mirror, a reference sign 120 indicates a bottom electrode, a reference sign 130 indicates a piezoelectric layer, a reference sign 140 indicates a top electrode, a reference sign 15 indicates an annular protruding structure, a reference sign 16 indicates a wing structure, a reference sign h1 indicates a height of a gap, a reference sign h2 indicates a thickness of the protruding structure 15, and a reference sign 17 indicates a bridge structure. Reference signs d11-d14 indicate various dimensions.

As shown in FIG. 1A, a composite structure is arranged at an edge of an effective region on an upper surface of the resonator. Accordingly, acoustic impedances on both sides of the edge of the effective region are not matched with each other, which limits propagation of transverse Lamb waves and enhances reflection and conversion capability to the Lamb waves, thereby improving the Rp. The piezoelectric layer has poor quality due to a rough edge of the bottom electrode at a connection side of the top electrode and the bottom electrode. The composite structure allows a resonance excitation caused by the piezoelectric layer with poor quality to contribute less to the entire circuit, and thus improves $K_{t,eff}^2$ and anti-static discharge performance.

FIG. 1B is a schematic structural sectional view of an existing film bulk acoustic wave resonator. As shown in FIG. 1B, a reference sign 100 indicates a substrate, a reference sign 110 indicates an acoustic mirror, a reference sign 120 indicates a bottom electrode, a reference sign 130 indicates a piezoelectric layer, a reference sign 140 indicates a top electrode, a reference sign 160 indicates an annular protruding structure, and a reference sign h2 indicates a thickness of the protruding structure. Reference signs d12 and d18 indicate various dimensions.

As shown in FIG. 1B, the annular protrusion 160 is a single-layer structure which may be made of a metal or a dielectric material, or may be formed by air. In this arrangement, a single-layer insertion structure is arranged in the piezoelectric layer, and thus electrical properties of the resonator such as Rp can be improved. However, in the conventional composite structure or the single-layer insertion structure as described above, the energy leakage at the edge of the effective region of the resonator cannot be effectively improved, and the Rp thus cannot be effectively improved.

**SUMMARY**

The present disclosure is provided to further improve an Rp value or a Qp value of a bulk acoustic wave resonator.

According to an aspect of embodiments of the present disclosure, there is provided a bulk acoustic wave resonator. The bulk acoustic wave resonator is provided with a composite insertion structure arranged in the middle of a piezoelectric layer in an edge region of an effective region of the resonator. The composite insertion structure has an insertion protrusion corresponding to a first insertion layer and an insertion wing-bridge corresponding to a second insertion layer, thereby effectively increasing the Rp value of the bulk acoustic wave resonator. The bulk acoustic wave resonator includes a substrate, an acoustic mirror, a bottom electrode, a top electrode, and a piezoelectric layer. The acoustic mirror, the bottom electrode, the piezoelectric layer and the top electrode overlap with each other in a thickness direction of the substrate to form an overlapping region, and the overlapping region is an effective region of the resonator. The piezoelectric layer is provided with a composite insertion structure arranged along an edge of the effective region, and the composite insertion structure includes a first insertion layer and a second insertion layer. In a top view of the resonator, at least part of the first insertion layer overlaps with the effective region, and in the top view of the resonator, the first insertion layer at least partially overlaps with the second insertion layer. The first insertion layer is made of a metallic material and the second insertion layer is formed of air or made of a dielectric material, or the first insertion layer is made of a dielectric material and the second insertion layer is formed of air.

Alternatively, at least part of the second insertion layer is arranged on the first insertion layer in a thickness direction of the resonator.

Alternatively, in a sectional view parallel to the thickness direction of the resonator, the second insertion layer covers and surrounds the first insertion layer or covers a part of the first insertion layer. Further alternatively, in the sectional view parallel to the thickness direction of the resonator, an outer end of a portion of the piezoelectric layer below the first insertion layer is arranged at an outer side of an outer end of a portion of the piezoelectric layer above the first insertion layer in a radial direction. Furthermore, alternatively, an outer end of the top electrode is aligned with the outer end of the portion of the piezoelectric layer above the first insertion layer in the sectional view parallel to the thickness direction of the resonator.

Alternatively, at least part of the first insertion layer is arranged on the second insertion layer in the thickness direction of the resonator. Further, alternatively, in a sectional view parallel to the thickness direction of the resonator, the first insertion layer covers and surrounds the second insertion layer or covers a part of the second insertion layer. Furthermore, alternatively, in the sectional view parallel to the thickness direction of the resonator, an outer end of a portion of the piezoelectric layer below the first insertion layer is arranged at an outer side of an outer end of a portion of the piezoelectric layer above the first insertion layer in a radial direction. Furthermore, alternatively, an outer end of the top electrode is aligned with the outer end of the portion of the piezoelectric layer above the first insertion layer and the outer end of the first insertion layer in the sectional view parallel to the thickness direction of the resonator.

Alternatively, in a top view of the resonator, the second insertion layer, the first insertion layer and the effective region at least partially overlap with each other.

Alternatively, the composite insertion structure is an annular insertion structure. Alternatively, the second insertion layer includes an insertion wing structure provided at a non-connection side of the electrodes in a top view of the resonator. Alternatively, the second insertion layer includes an insertion bridge structure provided at a connection side of the electrodes in a top view of the resonator. Further, a distance between an outer end of the insertion bridge structure and an end of the bottom electrode is in a range of 0 to 20 um in a radial direction. Furthermore, the first insertion layer extends beyond the bottom electrode, a distance between an outer end of the first insertion layer and the end of the bottom electrode is in a range of 0 to 10 um in the radial direction, and the distance between the outer end of the insertion bridge structure and the end of the bottom electrode in the radial direction is greater than the distance between the outer end of the first insertion layer and the end of the bottom electrode in the radial direction.

Alternatively, in a top view of the resonator, at least part of the first insertion layer overlapping with the effective region is a flat insertion portion. Alternatively, the first insertion layer is a flat layer protrusion. Alternatively, the first insertion layer includes the flat insertion portion and a protrusion step portion, and the protrusion step portion and the flat insertion portion form a step; and/or the second insertion layer includes a wing-bridge step portion.

Alternatively, at least part of the composite insertion structure is arranged at a middle position of a corresponding portion of the piezoelectric layer in a thickness direction of the piezoelectric layer.

Alternatively, in a radial direction, a distance between an inner end of the first insertion layer and an inner end of the second insertion layer is in a range of 0 to 10 um. Further, the first insertion layer, the second insertion layer and the effective region overlap with each other in a range of 0 to 10 um in the thickness direction of the resonator.

Alternatively, the first insertion layer has a thickness in a range of 50 A to 5000 A, and/or the second insertion layer has a thickness in a range of 50 A to 5000 A.

Alternatively, the metal material includes at least one of gold (Au), tungsten (W), molybdenum (Mo), platinum (Pt), ruthenium (Ru), iridium (Ir), titanium tungsten (TiW), aluminum (Al), titanium (Ti), osmium (Os), magnesium (Mg), gold (Au), tungsten (W), molybdenum (Mo), platinum (Pt), puthenium (Ru), iridium (Ir), germanium (Ge), copper (Cu), aluminum (Al), chromium (Cr), or arsenic doped gold. The dielectric material includes at least one of silicon dioxide ($SiO_2$), silicon nitride ($Si_3N_4$), silicon carbide (SiC), aluminum nitride (AlN), aluminum oxide ($Al_2O_3$), porous silicon, fluorinated amorphous carbon, fluoropolymer, parylene, polyarylene ether, hydrogen silsesquioxane, cross-linked polyphenylene polymer, bisphenylcyclobutene, fluorinated silica, carbon-doped oxide, or diamond.

Alternatively, the first insertion layer and/or the second insertion layer span/spans a boundary of the effective region.

Alternatively, the composite insertion structure is arranged between a first piezoelectric layer portion and a second piezoelectric layer portion, the first piezoelectric layer portion and the second piezoelectric layer portion form the piezoelectric layer, and a material of the first piezoelectric layer portion is different from a material of the second piezoelectric layer portion.

According to another aspect of embodiments of the present disclosure, there is provided a filter including the bulk acoustic wave resonator as described above.

According to a further aspect of embodiments of the present disclosure, there is provided an electronic device including the bulk acoustic wave resonator as described above or the filter as described above.

**BRIEF DESCRIPTION OF DRAWINGS**

The following description and drawings can facilitate to understand these and other features and advantages in various embodiments disclosed in the present disclosure. The same reference signs in the drawings always indicate the same components, wherein:

FIG. 1A is a schematic sectional view of a bulk acoustic wave resonator in the related art;
FIG. 1B is a schematic sectional view of a bulk acoustic wave resonator in the related art;
FIG. 2 is a schematic top view of a bulk acoustic wave resonator according to an exemplary embodiment of the present disclosure;
FIG. 2A is a schematic partial sectional view of the bulk acoustic wave resonator along line O-A in FIG. 2 according to an exemplary embodiment of the present disclosure;
FIG. 2B is a schematic view of a position arrangement of an insertion protrusion in a thickness direction of a piezoelectric layer according to an exemplary embodiment of the present disclosure;
FIG. 2C is a schematic partial sectional view of the bulk acoustic wave resonator along line O-B in FIG. 2 according to an exemplary embodiment of the present disclosure;
FIG. 2D is a schematic partial sectional view of the bulk acoustic wave resonator along line O-B in FIG. 2 according to another exemplary embodiment of the present disclosure;
FIG. 2E is a schematic partial sectional view of the bulk acoustic wave resonator along line O-B in FIG. 2 according to a further another exemplary embodiment of the present disclosure;
FIG. 2F is a schematic partial sectional view of the bulk acoustic wave resonator along line O-B in FIG. 2 according to a yet another exemplary embodiment of the present disclosure;
FIG. 3 is a schematic top view of a bulk acoustic wave resonator according to an exemplary embodiment of the present disclosure;
FIG. 3A is a schematic partial sectional view of the bulk acoustic wave resonator along line O-A in FIG.

3 according to an exemplary embodiment of the present disclosure;
FIG. 3B is a schematic partial sectional view of the bulk acoustic wave resonator along line O-B in FIG. 3 according to an exemplary embodiment of the present disclosure;
FIG. 3C is a schematic partial sectional view of the bulk acoustic wave resonator along line O-B in FIG. 3 according to another exemplary embodiment of the present disclosure;
FIG. 3D is a schematic partial sectional view along line O-B in FIG. 3 according to another exemplary embodiment of the present disclosure;
FIG. 4A is a schematic partial sectional view of a bulk acoustic wave resonator along a line in a position similar to line O-A in FIG. 2 according to an exemplary embodiment of the present disclosure;
FIG. 4B is a schematic partial sectional view of a bulk acoustic wave resonator along a line in a position similar to line O-A in FIG. 2 according to an exemplary embodiment of the present disclosure;
FIG. 5 is a comparison diagram of Rp values of structures shown in FIGS. 2A, 4A, and 1A; and
FIG. 6 is a comparison diagram of Rp values of a single-layer metal insertion structure, a single-layer air insertion structure, and a double-layer insertion structure (including a metal layer and an air layer).

**DESCRIPTION OF EMBODIMENTS**

The technical solutions of the present disclosure will be further described below in detail through embodiments and in conjunction with the drawings. The same or similar reference signs indicate the same or similar components throughout the description. The following description of embodiments of the present disclosure with reference to the drawings is intended to explain the general inventive concept of the present disclosure, and should not be construed as a limitation to the present disclosure.

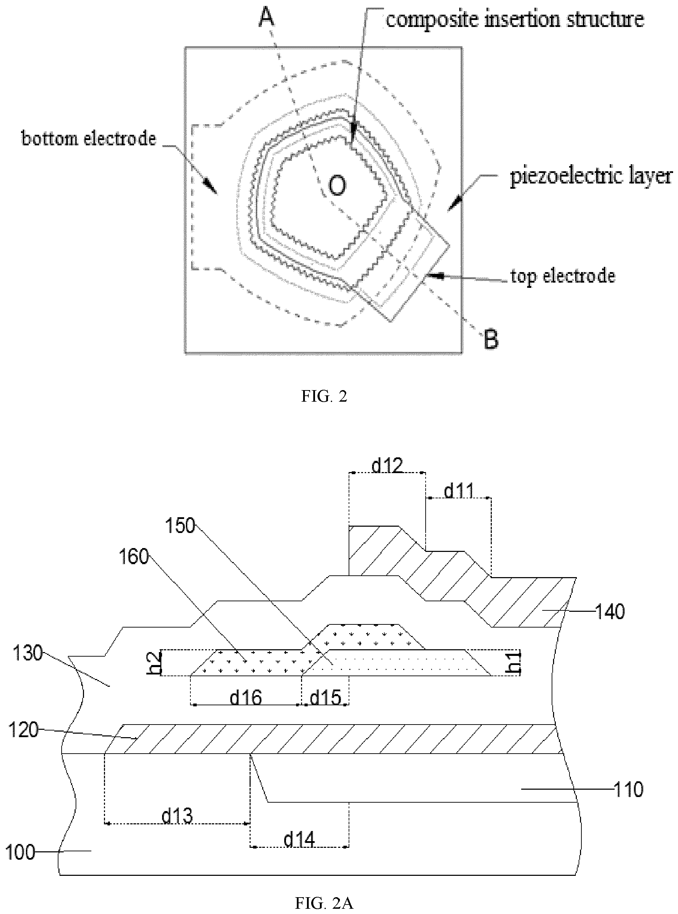

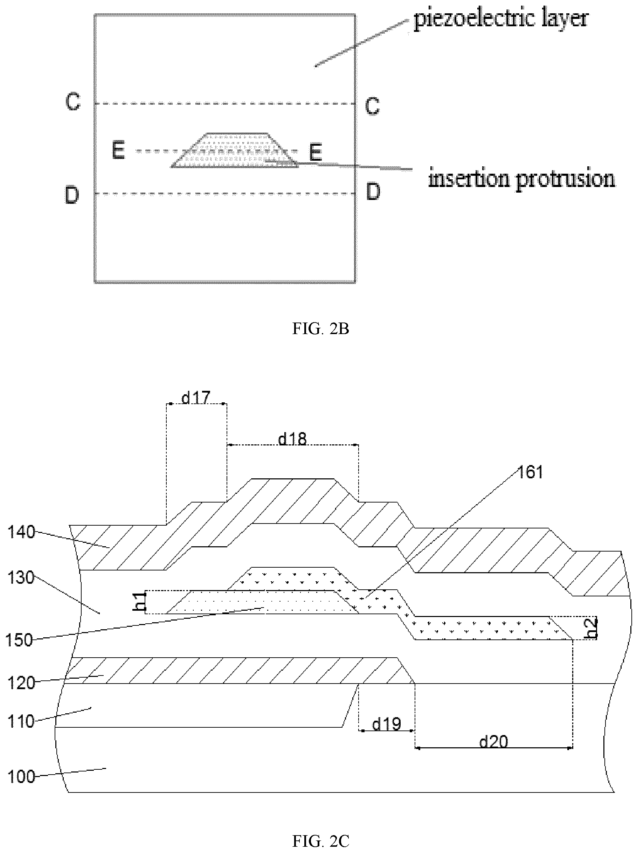

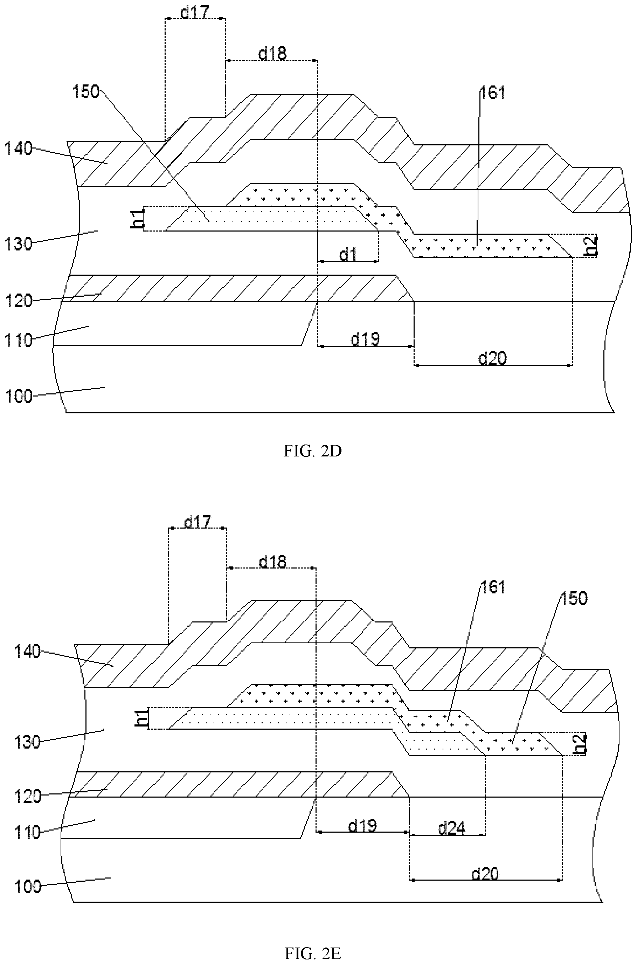

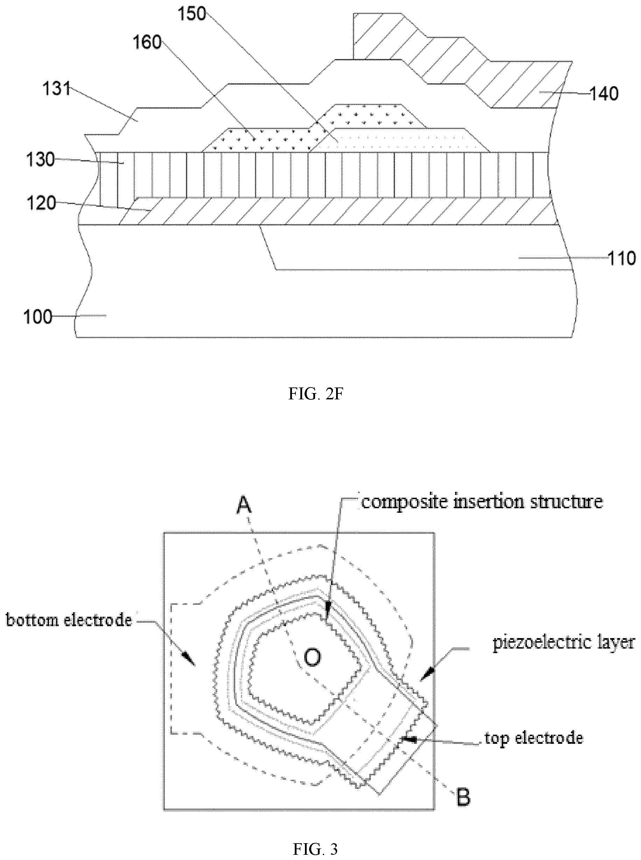

FIG. 2 is a schematic top view of a bulk acoustic wave resonator according to an exemplary embodiment of the present disclosure. As shown in FIG. 2, the bulk acoustic wave resonator includes a bottom electrode, a piezoelectric layer, a top electrode, and a composite annular insertion structure. The top electrode may be covered with a passivation layer. The composite annular insertion structure is composed of an annular insertion protrusion structure and an annular insertion wing-bridge structure. The annular insertion wing-bridge structure is formed as an annular wing structure at a non-connection side of the bottom electrode and the top electrode, and formed as an annular bridge structure at a connection side of the top electrode and the bottom electrode.

In the present disclosure, for example, as shown in FIG. 2, the composite insertion structure has a serrated shape. However, an actual shape of the composite insertion structure is not necessarily in a serrated shape. The composite insertion structure may have an edge shape parallel to an edge of the top electrode.

It should be noted that, in the present disclosure, the insertion structure may be annular or not, which all falls within the scope of the present disclosure.

FIG. 2A is a schematic partial sectional view of the bulk acoustic wave resonator along line O-A in FIG. 2 according to an exemplary embodiment of the present disclosure. As shown in FIG. 2A, the bulk acoustic wave resonator includes a substrate 100 and an acoustic mirror 110, which is located on an upper surface of the substrate or embedded in an interior thereof. As illustrated in FIG. 2A, the acoustic mirror is formed by a cavity embedded in the substrate, and any other acoustic mirror structures such as a Bragg reflector may also be applicable. The bulk acoustic wave resonator further includes a bottom electrode 120, a piezoelectric layer 130, a top electrode 140, an insertion protrusion 150, and an insertion wing 160. Further, the insertion protrusion 150 and the insertion wing 160 form a composite insertion structure. The top electrode 140 may be provided with a passivation layer. The bottom electrode 120 is deposited on an upper surface of the acoustic mirror and covers the acoustic mirror. The bottom electrode 120 may be etched into a bevel at an edge thereof, and the bevel is located outside the acoustic mirror. Further, the edge of the bottom electrode 120 may be etched into a stepped or vertical shape or other similar structures.

The acoustic mirror 110, the bottom electrode 120, the piezoelectric layer 130 and the top electrode 140 overlap with each other to form an overlapping region, which is an effective region of the resonator. The top electrode is located inside the acoustic mirror with a distance d14 in a range of 0 to 10 um from an edge of the acoustic mirror. The bottom electrode is located outside the acoustic mirror. A distance between a first end of the bottom electrode and the acoustic mirror is d13, and d13 is in a range of 0 to 10 um.

The insertion protrusion 150 has a first end (an inner end) and a second end (an outer end). In embodiments of the present disclosure, for all components, a side close to a center of the effective region in a radial or lateral direction is defined as an inner side, and a side away from the center of the effective region in the radial or lateral direction is defined as an outer side. The first end of the insertion protrusion 150 is located at the inner side of the effective region. The second end of the insertion protrusion 150 is aligned with an edge of the effective region, or extends beyond the effective region by a distance d15 in a range of 0 to 20 um. The first end of the insertion protrusion 150 is spaced apart from a first end of the insertion wing 160 by a distance d11 in a range of 0 to 10 um. The insertion protrusion has a height h1 in a range of 50 A to 5000 A.

The insertion wing 160 has the first end and a second end. The first end of the insertion wing 160 is located on the insertion protrusion 150 in a thickness direction, and is located between the edge of the effective region and the first end of insertion protrusion 150 in a horizontal direction. The second end of the insertion wing 160 is aligned with the edge of the effective region or extends beyond the effective region. The second end of the insertion wing 160 is spaced apart from the second end of the insertion protrusion 150 by a distance d16 in a range of 0 to 20 um. The first end of the insertion wing 160 is spaced apart from an edge of the top electrode 140 by a distance d12 in a range of 0 to 10 um. The insertion wing 160 has a height h2 in a range of 50 A to 5000 A.

It should be specially noted that, in the present disclosure, for a numerical range, the numerical range may not only include end values of the numerical range, but also include a mean value or midpoint value within the numerical range.

In this embodiment, the insertion protrusion 150 is made of a metal, such as Mo, W, Cu, or Al. The insertion wing 160 is made of a dielectric material such as $SiO_2$, $Si_3N_4$, ALN, doped AlN with a different doping concentration from the piezoelectric layer, or is formed of air.

FIG. 2B is a schematic view of a position arrangement of the insertion protrusion in a thickness direction of the piezoelectric layer according to an exemplary embodiment of the present disclosure. More specifically, in the thickness direction of the resonator, the piezoelectric layer is divided equally into three parts by lines C-C and D-D. In addition, line E-E is defined as a horizontal central line of the insertion protrusion, and is located in the middle of contour lines shown by the lines C-C and D-D. In FIG. 2A, the insertion protrusion may be arranged such that the insertion protrusion and the insertion wing overlap with each other to form an overlapping portion. In addition, such the overlapping portion may be formed in the piezoelectric layer.

In the present disclosure, the insertion protrusion is arranged in the middle of the piezoelectric layer as long as the insertion protrusion is arranged between the lines C-C and D-D.

In the embodiment as shown in FIG. 2A, a composite insertion layer (an insertion protruding layer corresponding to a first insertion layer and a wing-bridge layer corresponding to a second insertion layer) provided in the piezoelectric layer is located at a position where a stress is maximum in a resonator piston mode, which corresponds to a special arrangement in which the composite insertion layer is located in the middle of the piezoelectric layer. Accordingly, the resulting impedance mismatch has a stronger reflection effect on the acoustic waves. Meanwhile, compared to a single insertion layer such as a single protruding layer, arranging two insertion layers in the piezoelectric layer can provide an impedance mismatch interface between the effective region and an non-effective region of the resonator, so that leakage waves propagating laterally are reflected multiple times, thereby increasing a Q value of the resonator, especially a Q value (or a parallel resonance impedance Rp) of the resonator at a parallel resonance frequency.

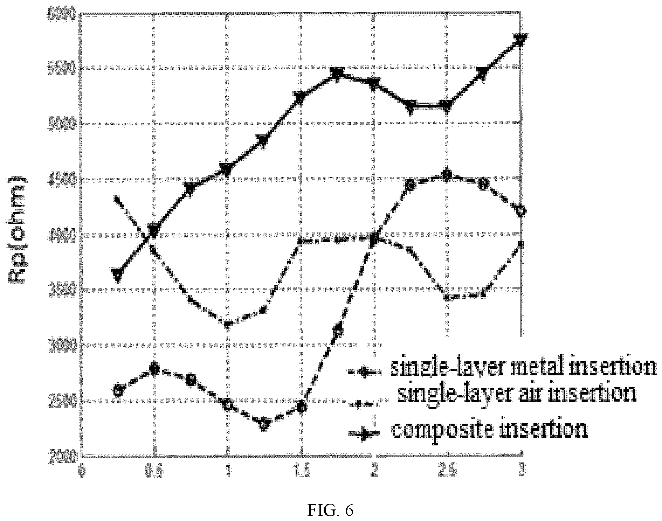

FIG. 6 illustrates a simulation comparison result of an arrangement in which for example a metal insertion layer and an air insertion layer are provided according to an exemplary embodiment of the present disclosure versus an arrangement in which for example a single metal layer or a single air layer is provided. As can be seen from FIG. 6, the present disclosure achieves a higher Rp value than the existing single-layer insertion structure.

FIG. 2C is a schematic partial sectional view of the bulk acoustic wave resonator along line O-B in FIG. 2 according to an exemplary embodiment of the present disclosure. In FIG. 2C, the bottom electrode extends beyond the acoustic mirror, and a distance d19 between an edge of the bottom electrode and the acoustic mirror is in a range of 0 to 10 um. The insertion protrusion 150 has a first end located inside the effective region and a second end aligned with the acoustic mirror. The first end of the insertion protrusion 150 is spaced apart from a first end of an insertion bridge 161 by a distance d17 in a range of 0 to 10 um. The insertion bridge 161 has the first end located on the insertion protrusion 150 in the thickness direction and a second end. The first end of the insertion bridge 161 is spaced apart from the edge of the acoustic mirror by a distance d18 in a range of 0 to 10 um. The second end of the insertion bridge 161 extends beyond the bottom electrode, and a distance d20 between the bottom electrode and the second end of the insertion bridge 161 is in a range of 0 to 20 um.

FIG. 2D is a schematic partial sectional view of the bulk acoustic wave resonator along line O-B in FIG. 2 according to another exemplary embodiment of the present disclosure. The embodiment shown in FIG. 2D is similar to that shown in FIG. 2C except that the second end of the insertion protrusion 150 extends beyond the effective region with an extension amount d1.

FIG. 2E is a schematic partial sectional view of the bulk acoustic wave resonator along line O-B in FIG. 2 according to a yet another exemplary embodiment of the present disclosure. The embodiment shown in FIG. 2E is similar to that shown in FIG. 2C except that the second end of the insertion protrusion structure 150 extends beyond the edge of the bottom electrode by an extension amount d24 in a range of 0 to 10 um. In this arrangement, the process tolerance is increased.

FIG. 2F is a schematic partial sectional view of the bulk acoustic wave resonator along line O-B in FIG. 2 according to a still another exemplary embodiment of the present disclosure. The embodiment shown in FIG. 2F is similar to that in FIG. 2A except that the piezoelectric layer is made of two different piezoelectric materials or piezoelectric materials with different doping concentrations. In this embodiment, a first piezoelectric layer 130 is made of pure ALN, and a second piezoelectric layer 131 is made of doped ALN.

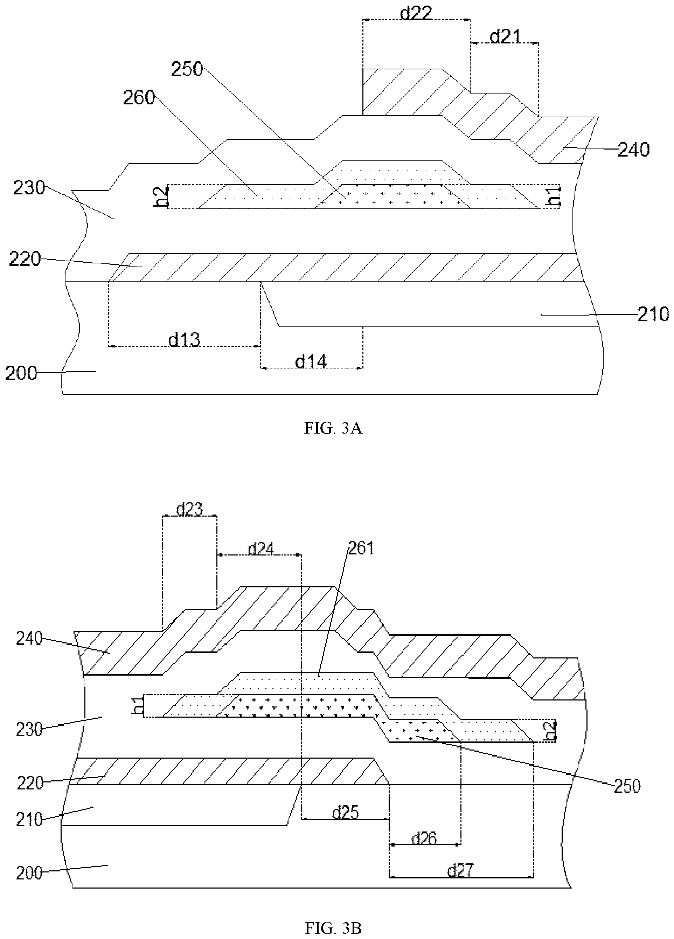

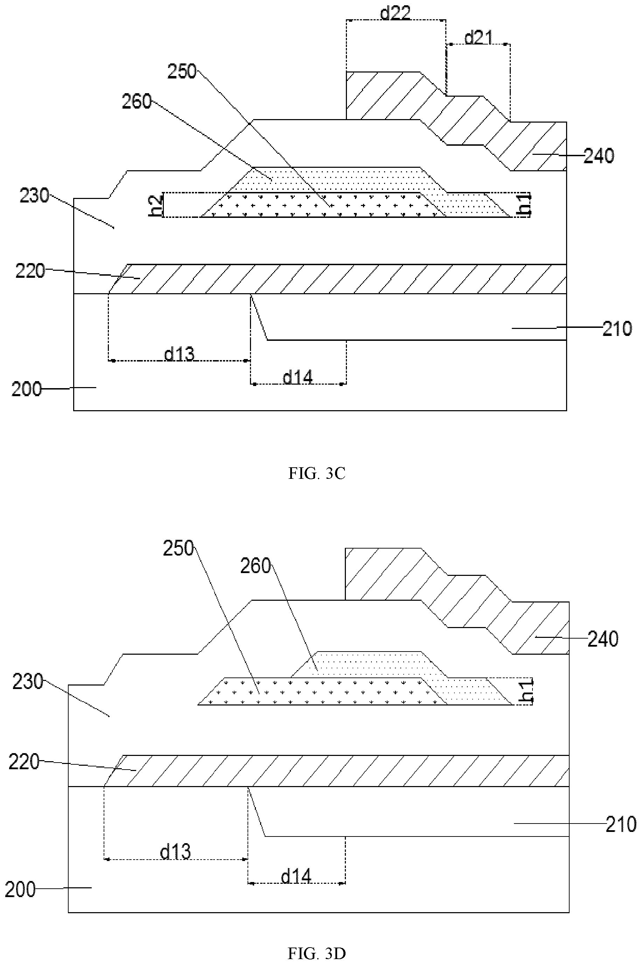

FIG. 3 is a schematic top view of a bulk acoustic wave resonator according to an exemplary embodiment of the present disclosure. In the embodiment shown in FIG. 3, the bulk acoustic wave resonator includes a bottom electrode, a piezoelectric layer, a top electrode, and a composite annular insertion structure. The composite annular insertion structure is composed of an annular insertion protrusion and an annular insertion wing-bridge structure. The annular insertion wing-bridge structure is formed as an annular wing structure at a non-connection side of the bottom electrode and the top electrode, and is formed as an annular bridge structure at a connection side of the top electrode and the bottom electrode.

FIG. 3A is a schematic partial sectional view of the bulk acoustic wave resonator along line O-A in FIG. 3 according to an exemplary embodiment of the present disclosure. As shown in FIG. 3A, the bulk acoustic wave resonator includes a substrate 200 and an acoustic mirror 210 provided on an upper surface of the substrate or embedded in an interior of the substrate. As illustrated in FIG. 3A, the acoustic mirror is formed by a cavity provided in the substrate, and any other acoustic mirror structures such as a Bragg reflector may be applicable. The bulk acoustic wave resonator further includes a bottom electrode 220, a piezoelectric layer 230, a top electrode 240, an insertion protruding structure 250, and an insertion wing structure 260. Further, the insertion protruding structure 250 and the insertion wing structure 260 form a composite insertion structure. The bottom electrode 220 is deposited on an upper surface of the acoustic mirror and covers the acoustic mirror. The bottom electrode 220 is etched into a bevel at an edge thereof, and the bevel is located outside the acoustic mirror. Alternatively, the edge of the bottom electrode 220 may be etched into a stepped shape, a vertical shape or other similar structures.

The acoustic mirror 210, the bottom electrode 220, the piezoelectric layer 230 and the top electrode 240 overlap with each other to form an overlapping region, which is an effective region of the resonator. The top electrode is located inside the acoustic mirror, and a distance d14 between the top electrode and the acoustic mirror is in a range of 0 to 10 um. The bottom electrode is located outside the acoustic mirror, a distance between a first end of the bottom electrode and the acoustic mirror is d13, and the distance d13 is in a range of 0 to 10 um. The insertion wing structure 250 has a first end located inside the effective region and a second end aligned with the edge of the effective region or extending beyond the effective region. The first end of the insertion wing structure 250 is spaced apart from a first end of the top electrode 240 by a distance d22, which is in a range of 0 to 10 um. The insertion wing structure has a height h1 in a range of 50 A to 5000 A. The insertion protrusion 260 has a first end and a second end. The first end of the insertion protrusion 260 is located inside the effective region. The first end of the insertion protrusion 260 is located closer to a center of the resonator than the first end of the insertion wing structure 250. The first end of the insertion protrusion 260 is spaced apart from the first end of the insertion wing structure 250 by a distance d21, which is in a range of 0 to 10 um. The second end of the insertion protrusion 260 may be located on the insertion wing structure 250 beyond an outer edge of the top electrode. Alternatively, the insertion protrusion 260 may cover the insertion wing structure and extend outwardly to a non-effective region.

In the present disclosure, when the insertion protrusion (layer) is made of a metal material, the bridge-wing layer is formed of air or made of a dielectric material. In this case, the bridge-wing layer may be the insertion bridge or the insertion wing, or the insertion bridge and the insertion wing. In the present disclosure, when the insertion protrusion is made of a dielectric material, the bridge-wing layer is formed of air.

In addition, in the present disclosure, the insertion protrusion may be located on the bridge-wing layer. Alternatively, the bridge-wing layer may be located above the insertion protrusion.

FIG. 3B is a schematic partial sectional view of the bulk acoustic wave resonator along line O-B in FIG. 3 according to an exemplary embodiment of the present disclosure. In

FIG. 3B, the bottom electrode extends beyond the acoustic mirror, a distance between an edge of the bottom electrode and the acoustic mirror is defined as d25, and the distance d25 is in a range of 0 to 10 um. The insertion bridge structure 250 has a first end located inside the effective region and a second end located outside the bottom electrode, a distance between the second end of the insertion bridge structure 250 and an end of the bottom electrode is defined as d26, and the distance d26 is in a range of 0 to 10 um. The insertion protrusion 261 has a first end and a second end, and the first end of the insertion protrusion 261 is located closer to the center of the resonator than the first end of the insertion bridge 250. The first end of the insertion protrusion 261 is spaced apart from the first end of the insertion bridge structure by a distance d23, which is in a range of 0 to 10 um. Preferably, the second end of the insertion protrusion 261 extends outwardly beyond the second end of the insertion bridge structure. The second end of the insertion protrusion 261 is spaced apart from the edge of the bottom electrode by a distance d27, which is in a range of 0 to 20 um.

FIG. 3C is a schematic partial sectional view of the bulk acoustic wave resonator along line O-B in FIG. 3 according to another exemplary embodiment of the present disclosure. The embodiment shown in FIG. 3C is similar to that shown in FIG. 3B except that the second end of the insertion wing structure 260 is aligned with the second end of the insertion protrusion structure 250 rather than wrapping around the second end of the insertion protrusion structure 250 in FIG. 3C.

In the present disclosure, in a sectional view parallel to the thickness direction of the resonator, the insertion wing structure may cover and surround the insertion protrusion structure or a part of the insertion protrusion structure. FIG. 3D illustrates a corresponding exemplary embodiment. FIG. 3D is a schematic partial sectional view of the bulk acoustic wave resonator along line O-B in FIG. 3 according to another exemplary embodiment of the present disclosure. The embodiment shown in FIG. 3D is similar to that shown in FIG. 3B except that in FIG. 3D, the second end of the insertion wing structure 260 is located at an inner side of the second end of the insertion protrusion structure 260, rather than wrapping around the second end of the insertion protrusion structure 250.

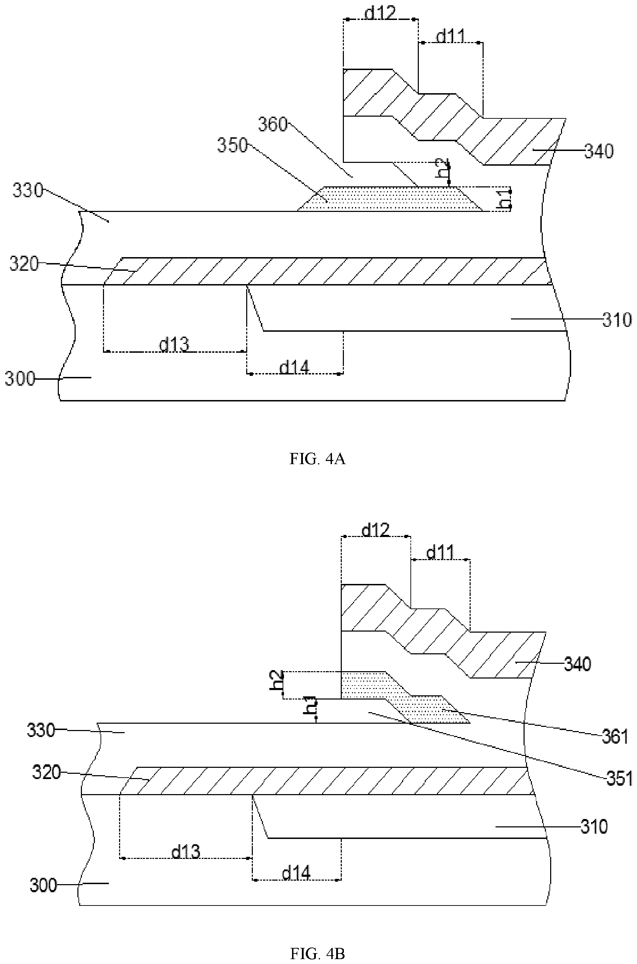

FIG. 4A is a schematic partial sectional view of a bulk acoustic wave resonator along a line in a position similar to line O-A in FIG. 2 according to an exemplary embodiment of the present disclosure. The embodiment shown in FIG. 4A is similar to that shown in FIG. 2A except that at an outer side of the edge of the effective region, a portion of the piezoelectric layer 130 on the composite insertion layer (the insert protrusion 350 corresponding to the first insertion layer and the insert wing structure corresponding to the second layer) is etched, and the first end of the top electrode overlaps with the first end of the piezoelectric layer in the thickness direction.

As shown in FIG. 4A, the insertion wing structure 360 has a height h2 and a width d12. A first end of the insertion protrusion 350 is laterally located closer to the center of the resonator than the insertion wing structure 360, and is spaced apart from a first end of the insertion wing structure 360 by a distance d11. Further, a second end of the insertion protrusion 350 may be aligned with a second end of the insertion wing structure 360 or extend outwardly to a non-effective region.

In the above exemplary embodiments, the insertion wing structure is made of a dielectric material such as $SiO_2$, $Si_3N_4$, ALN or doped AIN with a different doping concentration from that of the piezoelectric layer, or is formed of air. The insertion protrusion is made of a metal.

In other words, in a sectional view parallel to the thickness direction of the resonator as shown in FIG. 4A, the second insertion layer (i.e., the insertion wing structure) covers and surrounds the first insertion layer (i.e., the insertion protrusion), or covers a part of the first insertion layer. Further, in a sectional view parallel to the thickness direction of the resonator, an outer end of a portion of the piezoelectric layer below the first insertion layer is located at an outer side of an outer end of a portion of the piezoelectric layer above the first insertion layer in the radial direction. Furthermore, in a sectional view parallel to the thickness direction of the resonator, an outer end of the top electrode is aligned with the outer end of the portion of the piezoelectric layer above the first insertion layer.

FIG. 4B is a schematic partial sectional view of a bulk acoustic wave resonator along a line in a position similar to line O-A in FIG. 2 according to an exemplary embodiment of the present disclosure. The embodiment shown in FIG. 4B is similar to that shown in FIG. 4A except for an annular insertion protrusion structure 361 and an annular insertion wing structure 351. The annular insertion wing structure 351 has a height h1 and a lateral distance d12, and is made of a dielectric material. A first end of the insertion protrusion structure 361 is located closer to the center of the resonator. The first end of the insertion protrusion structure 361 is spaced apart from a first end of the annular insertion wing structure 351 by a distance d11, and a second end of the insertion protruding structure 361 is at least connected to the insertion wing structure or extends outwardly, preferably parallel to the edge of the effective region.

In other words, in FIG. 4B, in the thickness direction of the resonator, at least part of the insertion protrusion structure corresponding to the first insertion layer is located above the insertion wing structure corresponding to the second insertion layer. Further, in a sectional view parallel to the thickness direction of the resonator, the first insertion layer covers and surrounds the second insertion layer or covers a part of the second insertion layer. Furthermore, in a sectional view parallel to the thickness direction of the resonator, the outer end of the portion of the piezoelectric layer below the first insertion layer is located at the outer side of the outer end of the portion of the piezoelectric layer above the first insertion layer in the radial direction.

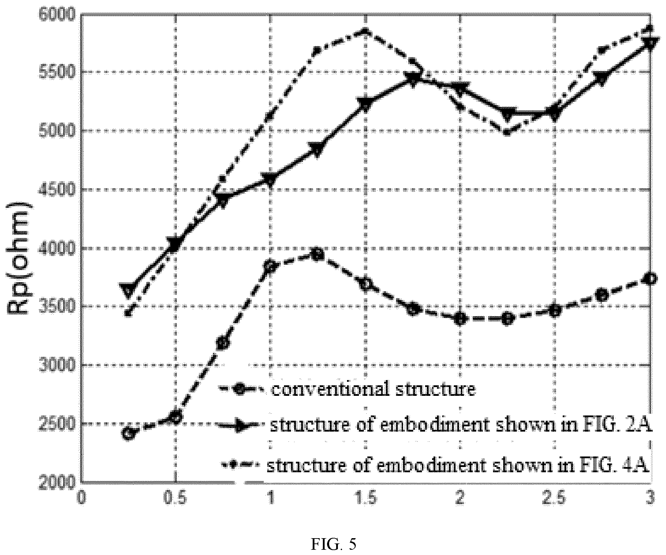

FIG. 5 is a performance comparison diagram of Rp values of structures as shown in FIGS. 2A, 4A and 1A. In this embodiment, the insertion wing is formed of air, and has a height h2 of 1000 A and a width d12 of 1 um. The annular protrusion 150 is made of Mo (molybdenum) and has a height h1 of 1300 A. As shown in FIG. 5, when an effective length d11 of the annular protrusion has been increased from 0.5 um to 3 um, parallel resistances (Rp) of the two composite insertion structures both are significantly greater than that of the conventional composite structure. In the embodiment in which the piezoelectric layer is partially etched in the two composite insertion structures, an average value of the parallel resistances Rp is significantly superior as compared with that of the entire piezoelectric layer. When the effective length d11 of the annular protrusion is 1.5 um and 3 um, the partial piezoelectric composite insertion structure has a maximum Rp which may be is high up to 5800 ohms. When the effective length d11 of the annular protrusion is 1.5 um, the Rp value of the entire piezoelectric composite insertion structure is 5250A ohm. The Rp value of the conventional composite structure is 3700 ohms, and Rp values of parts of the piezoelectric composite insertion structure are greater than the entire piezoelectric composite insertion structure and the conventional composite structure by 56.8% and 10.5%, respectively.

In the above embodiments, when the second insertion layer is configured to be a wing, the second insertion layer has a wing structure. Alternatively, when the second insertion layer is configured to be a bridge, the second insertion layer has a bridge structure. Thus, the resonator may include only the wing structure or the bridge structure, or may include both the bridge structure and the wing structure, as desired.

The materials of the components of the bulk acoustic wave resonator according to the present disclosure will be described briefly below.

In the present disclosure, the electrodes and the insertion protrusion may be made of gold (Au), tungsten (W), molybdenum (Mo), platinum (Pt), ruthenium (Ru), iridium (Ir), titanium tungsten (TiW), aluminum (Al), titanium (Ti), osmium (Os), magnesium (Mg), gold (Au), tungsten (W), molybdenum (Mo), platinum (Pt), ruthenium (Ru), iridium (Ir), germanium (Ge), copper (Cu), aluminum (Al), chromium (Cr), arsenic-doped gold and other similar metals.

In the present disclosure, the passivation layer is made of a dielectric material, and the wing-bridge structure is also made of a dielectric material. The dielectric material may be selected from, but not limited to, one or more of silicon dioxide ($SiO_2$), silicon nitride ($Si_3N_4$), silicon carbide (SiC), aluminum nitride (AlN), aluminum oxide ($Al_2O_3$), porous silicon, fluorinated amorphous carbon, fluoropolymer, parylene, polyarylene ether, hydrogen silsesquioxane, cross-linked polyphenylene polymer, bisphenylcyclobutene, fluorinated silica, carbon-doped oxide and diamond, or a combination thereof.

In the present disclosure, the piezoelectric layer may be made of aluminum nitride (AlN), doped aluminum nitride (doped ALN), zinc oxide (ZnO), lead zirconate titanate (PZT), lithium niobate ($LiNbO_3$), quartz, potassium niobate ($KNbO_3$) or lithium tantalate ($LiTaO_3$), and the like. The doped ALN contains at least one rare earth element, such as scandium (Sc), yttrium (Y), magnesium (Mg), titanium (Ti), lanthanum (La), cerium (Ce), praseodymium (Pr), neodymium (Nd), promethium (Pm), samarium (Sm), europium (Eu), gadolinium (Gd), terbium (Tb), dysprosium (Dy) , holmium (Ho), erbium (Er), thulium (Tm), ytterbium (Yb), and lutetium (Lu).

In the present disclosure, the substrate is made of monocrystal silicon (Si), gallium arsenide (GaAs), sapphire, quartz or the like. However, the material of the substrate is not limited thereto.

In view of the above description, the following technical solutions are provided.

1. A bulk acoustic wave resonator includes:

    a substrate;
    an acoustic mirror;
    a bottom electrode;
    a top electrode; and
    a piezoelectric layer,
    wherein the acoustic mirror, the bottom electrode, the piezoelectric layer and the top electrode overlap with each other in a thickness direction of the substrate to form an overlapping region, which is an effective region of the resonator;

    wherein the piezoelectric layer is provided with a composite insertion structure arranged along an edge of the effective region, the composite insertion structure includes a first insertion layer and a second insertion layer, at least part of the first insertion layer overlaps with the effective region in a top view of the resonator, and the first insertion layer at least partially overlaps with the second insertion layer in the top view of the resonator; and

wherein the first insertion layer is made of a metallic material and the second insertion layer is formed of air or made of a dielectric material, or the first insertion layer is made of a dielectric material and the second insertion layer is formed of air.

Alternatively, in the top view of the resonator, the second insertion layer, the first insertion layer and the effective region at least partially overlap with each other.

Alternatively, the first insertion layer and/or the second insertion layer span(s) a boundary of the effective region.

2. A filter includes the resonator as described above.
3. An electronic device incudes the resonator as described above or the filter as described above. It should be noted that the electronic device herein includes, but is not limited to, intermediate products such as radio frequency front-ends, filter and amplifier modules, and terminal products such as mobile phones, WIFI, and drones.

Although the embodiments of the present disclosure have been shown and described, it should be understood for those skilled in the art that modifications may be made to these embodiments without departing from the principle and spirit of the present disclosure, and the scope thereof is defined by the appended claims and their equivalents.

## Claims

1.  A bulk acoustic wave resonator, comprising:

    a substrate;
    an acoustic mirror;
    a bottom electrode;
    a top electrode; and
    a piezoelectric layer,
    wherein the acoustic mirror, the bottom electrode, the piezoelectric layer and the top electrode overlap with each other in a thickness direction of the substrate to form an overlapping region, and the overlapping region is an effective region of the resonator;
    wherein the piezoelectric layer is provided with a composite insertion structure arranged along an edge of the effective region, the composite insertion structure comprises a first insertion layer and a second insertion layer, wherein in a top view of the resonator, at least part of the first insertion layer overlaps with the effective region, and in the top view of the resonator, the first insertion layer at least partially overlaps with the second insertion layer; and
wherein the first insertion layer is made of a metallic material and the second insertion layer is formed of air or made of a dielectric material, or the first insertion layer is made of a dielectric material and the second insertion layer is formed of air.

2.  The resonator according to claim 1, **characterized in that** in a thickness direction of the resonator, at least part of the second insertion layer is arranged on the first insertion layer.

3.  The resonator according to claim 2, **characterized in that** in a sectional view parallel to the thickness direction of the resonator, the second insertion layer covers and surrounds the first insertion layer or covers a part of the first insertion layer.

4.  The resonator according to claim 3, **characterized in that** in the sectional view parallel to the thickness direction of the resonator, an outer end of a portion of the piezoelectric layer below the first insertion layer is arranged at an outer side of an outer end of a portion of the piezoelectric layer above the first insertion layer in a radial direction.

5.  The resonator according to claim 4, **characterized in that** in the sectional view parallel to the thickness direction of the resonator, an outer end of the top electrode is aligned with the outer end of the portion of the piezoelectric layer above the first insertion layer.

6.  The resonator according to claim 1, **characterized in that** in a thickness direction of the resonator, at least part of the first insertion layer is arranged on the second insertion layer.

7.  The resonator according to claim 6, **characterized in that** in a sectional view parallel to the thickness direction of the resonator, the first insertion layer covers and surrounds the second insertion layer or covers a part of the second insertion layer.

8.  The resonator according to claim 7, **characterized in that** in the sectional view parallel to the thickness direction of the resonator, an outer end of a portion of the piezoelectric layer below the first insertion layer is arranged at an outer side of an outer end of a portion of the piezoelectric layer above the first insertion layer in a radial direction.

9.  The resonator according to claim 8, **characterized**

**in that** in the sectional view parallel to the thickness direction of the resonator, an outer end of the top electrode is aligned with an outer end of the first insertion layer and the outer end of the portion of the piezoelectric layer above the first insertion layer.

10. The resonator according to claim 1, **characterized in that** in a top view of the resonator, the second insertion layer, the first insertion layer and the effective region at least partially overlap with each other.

11. The resonator according to claim 1, **characterized in that** the composite insertion structure is an annular insertion structure.

12. The resonator according to claim 11, **characterized in that** in a top view of the resonator, the second insertion layer comprises an insertion wing structure provided at a non-connection side of the electrodes.

13. The resonator according to claim 11, **characterized in that** in a top view of the resonator, the second insertion layer comprises an insertion bridge structure provided at a connection side of the electrodes.

14. The resonator according to claim 13, **characterized in that** a distance between an outer end of the insertion bridge structure and an end of the bottom electrode in a radial direction is in a range of 0 to 20 um.

15. The resonator according to claim 14, **characterized in that** the first insertion layer extends beyond the bottom electrode, a distance between an outer end of the first insertion layer and the end of the bottom electrode in the radial direction is in a range of 0 to 10 um, and the distance between the outer end of the insertion bridge structure and the end of the bottom electrode in the radial direction is greater than the distance of the outer end of the first insertion layer and the end of the bottom electrode in the radial direction.

16. The resonator according to claim 1, **characterized in that** in a top view of the resonator, at least part of a portion of the first insertion layer overlapping with the effective region is a flat insertion portion.

17. The resonator according to claim 16, **characterized in that** the first insertion layer is a flat layer protrusion.

18. The resonator according to claim 16, **characterized in that** the first insertion layer comprises the flat insertion portion and a protrusion step portion, and the protrusion step portion and the flat insertion portion form a step; and/or the second insertion layer comprises a wing-bridge step portion.

19. The resonator according to claim 1, **characterized in that** in a thickness direction of the piezoelectric layer, at least part of the composite insertion structure is arranged at a middle position of a corresponding portion of the piezoelectric layer.

20. The resonator according to any one of claims 1 to 19, **characterized in that** an inner end of the first insertion layer is spaced apart from an inner end of the second insertion layer by a distance in a radial direction, and the distance is in a range of 0 to 10 um.

21. The resonator according to claim 20, **characterized in that** the first insertion layer, the second insertion layer and the effective region overlap with each other in a range of 0 to 10 um in the thickness direction of the resonator.

22. The resonator according to any one of claims 1 to 20, **characterized in that** the first insertion layer has a thickness in a range of 50 A to 5000 A, and/or the second insertion layer has a thickness in a range of 50 A to 5000 A.

23. The resonator according to any one of claims 1 to 22, **characterized in that** the metal material comprises at least one of gold (Au), tungsten (W), molybdenum (Mo), platinum (Pt), ruthenium (Ru), iridium (Ir), titanium tungsten (TiW) , aluminum (Al), titanium (Ti), osmium (Os), magnesium (Mg), gold (Au), tungsten (W), molybdenum (Mo), platinum (Pt), puthenium (Ru), iridium (Ir), germanium (Ge), copper (Cu), aluminum (Al), chromium (Cr), or arsenic doped gold; and
the dielectric material comprises at least one of silicon dioxide ($SiO_2$), silicon nitride ($Si_3N_4$), silicon carbide (SiC), aluminum nitride (AlN), aluminum oxide ($Al_2O_3$), porous silicon, fluorinated amorphous carbon, fluoropolymer, parylene, polyarylene ether, hydrogen silsesquioxane, cross-linked polyphenylene polymer, bisphenylcyclobutene, fluorinated silica, carbon-doped oxide, or diamond.

24. The resonator according to claim 1, **characterized in that** the first insertion layer and/or the second insertion layer span/spans a boundary of the effective region.

25. The resonator according to claim 1, **characterized in that** the composite insertion structure is arranged between a first piezoelectric layer portion and a second piezoelectric layer portion, the first piezoelectric layer portion and the second piezoelectric layer portion form the piezoelectric layer, and a material of the first piezoelectric layer portion is different from a material of the second piezoelectric layer portion.

26. A filter, comprising the bulk acoustic wave resonator according to any one of claims 1 to 25.

27. An electronic device, comprising the bulk acoustic wave resonator according to any one of claims 1 to 25 or the filter according to claim 27.

FIG. 1A

FIG. 1B

A

composite insertion structure

bottom electrode

O

piezoelectric layer

top electrode

B

FIG. 2

d12

d11

150

160

140

130

h2

h1

d16    d15

120

d13

110

d14

100

FIG. 2A

FIG. 2B

FIG. 2C

FIG. 2D

FIG. 2E

150

160

131

130

120

110

100

FIG. 2F

140

A

composite insertion structure

bottom electrode

O

piezoelectric layer

top electrode

B

FIG. 3

FIG. 3A

FIG. 3B

FIG. 3C

FIG. 3D

FIG. 4A

FIG. 4B

FIG. 5

FIG. 6

## INTERNATIONAL SEARCH REPORT

| International application No. |
| --- |
| **PCT/CN2020/086562** |

### A. CLASSIFICATION OF SUBJECT MATTER

H03H 3/02(2006.01)i; H03H 9/02(2006.01)n; H03H 9/17(2006.01)n; H03H 9/54(2006.01)n

According to International Patent Classification (IPC) or to both national classification and IPC

### B. FIELDS SEARCHED

Minimum documentation searched (classification system followed by classification symbols)

H03H

Documentation searched other than minimum documentation to the extent that such documents are included in the fields searched

Electronic data base consulted during the international search (name of data base and, where practicable, search terms used)

CNABS; CNTXT; CNKI; VEN; USTXT; WOTXT; EPTXT; IEEE: 声波, 谐振器, 电极, 压电, 空气, 复合, 插入, sound wave, resonator, electrode, piezoelectric, air, composite, insert

### C. DOCUMENTS CONSIDERED TO BE RELEVANT

| Category* | Citation of document, with indication, where appropriate, of the relevant passages | Relevant to claim No. |
| --- | --- | --- |
| PX | CN 111010104 A (TIANJIN UNIVERSITY et al.) 14 April 2020 (2020-04-14)<br>claims 1-27 | 1-27 |
| X | CN 109831175 A (TIANJIN UNIVERSITY et al.) 31 May 2019 (2019-05-31)<br>description paragraphs [0034]-[0070], figures 2-11 | 1-27 |
| X | US 2016118957 A1 (AVAGO TECHNOLOGIES GENERAL IP (SINGAPORE) PTE. LTD.)<br>28 April 2016 (2016-04-28)<br>description, paragraphs [0017]-[0120], and figure 3 | 1-27 |
| X | US 2011227671 A1 (ZHANG HAO) 22 September 2011 (2011-09-22)<br>description, paragraphs [0049]-[0079], and figure 3 | 1-27 |
| A | US 2017310303 A1 (AVAGO TECH GENERAL IP SINGAPORE PTE LTD) 26 October<br>2017 (2017-10-26)<br>entire document | 1-27 |

☐ Further documents are listed in the continuation of Box C.  ☑ See patent family annex.

| * Special categories of cited documents: | |
| --- | --- |
| "A" document defining the general state of the art which is not considered to be of particular relevance | "T" later document published after the international filing date or priority date and not in conflict with the application but cited to understand the principle or theory underlying the invention |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **26 May 2020** | **15 July 2020** |

| Name and mailing address of the ISA/CN | Authorized officer |
| --- | --- |
| **China National Intellectual Property Administration (ISA/ CN)**<br>**No. 6, Xitucheng Road, Jimenqiao Haidian District, Beijing 100088**<br>**China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2020/086562**

| Patent document cited in search report | | | Publication date (day/month/year) | Patent family member(s) | | | Publication date (day/month/year) |
|---|---|---|---|---|---|---|---|
| CN | 111010104 | A | 14 April 2020 | None | | | |
| CN | 109831175 | A | 31 May 2019 | None | | | |
| US | 2016118957 | A1 | 28 April 2016 | US | 9621126 | B2 | 11 April 2017 |
| | | | | DE | 102015117953 | B4 | 11 October 2018 |
| | | | | DE | 102015117953 | A1 | 28 April 2016 |
| US | 2011227671 | A1 | 22 September 2011 | US | 8253513 | B2 | 28 August 2012 |
| US | 2017310303 | A1 | 26 October 2017 | US | 10128813 | B2 | 13 November 2018 |
| | | | | DE | 102017108340 | A1 | 26 October 2017 |

Form PCT/ISA/210 (patent family annex) (January 2015)